# EUROPEAN PATENT APPLICATION

(11) **EP 3 578 912 A1**
(43) Date of publication of application: **11.12.2019**
(21) Application number: 18175797.2
(22) Date of filing: 04.06.2018
(51) Int. Cl.: F28D 15/02, H01L 23/427, H01L 23/473, H05K 7/20

(54) **COOLING SYSTEM FOR A COMPUTER**

(71) Applicant: Monster Labo, 6221 St Amand (BE)
(72) Inventor: BOUVE, Quentin, 59670 Sainte-Marie-Cappel (FR); DEPRET, Nicolas, 6221 St Amand (BE)
(74) Representative: Gevers Patents

(57) **Abstract**

The present invention relates to a cooling system (1) for a computer. The cooling system (1) comprises a radiator (50) with fins (51a-n), first heat pipes (12a-n) and second heat pipes (22a-n). The first heat pipes (12a-n) can be thermally connected to a central computer unit (15) to extract its heat. The second heat pipes (22a-n) can be thermally connected to a graphical computer unit (25) to extract its heat. The heat is then transferred by the first and second heat pipes to the fins at heat releasing areas (18i, 28i). For each fin, the heat releasing areas of the various heat pipes are distributed within the fin to efficiently distribute the heat on its full external surface.

## Description

### Field of the invention

The present invention relates to a cooling system for a computer.

### Background of the invention

Document US9069535B2 describes a cooling system for a computer. This cooling system is adapted for a computer with a cylindrical shape, but not for a standard computer shape. Moreover, this known system requires a high volume to obtain an efficient heat removal.

### Summary of the invention

An object of the invention is to provide a cooling system for a computer of any shape, and more specifically for a cuboid computer, and which is especially efficient in heat removal. According to an embodiment, the invention relates to a cooling system for a computer comprising:
- a radiator comprising fins;
- first thermal transfer means arranged for transferring heat from a central computing unit to the radiator;
- second thermal transfer means arranged for transferring heat from a graphical computing unit to the radiator;
**characterized in that**
the first thermal transfer means comprise first heat pipes, each first heat pipe being arranged for receiving heat from the central computing unit over a first heat receiving area;
the second thermal transfer means comprise second heat pipes, each second heat pipe being arranged for receiving heat from the graphical computing unit over a second heat receiving area;
the first heat pipes are in thermal contact with at least some of the fins over first heat releasing areas, and the second heat pipes are in thermal contact with at least some of the fins over second heat releasing areas, the first and second releasing areas being different from each others and being inside the fins; and
the cooling system has a first position such that:
- for each first heat pipe, the first heat releasing areas are at a same height or higher than the first heat receiving area,
- for each second heat pipe, the second heat releasing areas are at a same height or higher than the second heat receiving area.

The use of heat pipes for transferring heat from the central computing unit (CPU) and the graphical computing unit (GPU) to the radiator provides several advantages, especially when combined with other features according to the invention.

First, it provides an excellent heat transfer means.

Second, the inventors have found that heat pipes provide a lot of freedom on the respective positions of the CPU, the GPU and the fins because heat pipes can take many shapes.

This freedom on the positions of the CPU, the GPU and the radiator makes also possible that, for each first (respectively second) heat pipe, the first (respectively second) heat receiving area, which is the area where the first (respectively second) heat pipe receives heat, is lower or at the same level than the first (respectively second) heat releasing areas, which are the areas where the first (respectively second) heat pipe releases heat. In releasing heat, the fluid inside the first (respectively second) heat pipes condensates and because of gravity, easily goes back to the first (respectively second) heat receiving area. In other words, the respective positions of the CPU, the GPU and the heat releasing areas within the fins are such that gravity increases the efficiency of the system.

Third, the inventors have found that heat pipes make possible to especially efficiently distribute heat amongst the fins of the radiator. It is particularly the case in the invention because heat releasing areas are different for each heat pipe. Therefore, each fin gets heat from each heat pipe at a different location, which spread the heat and improves the cooling. Moreover, since the heat releasing areas are inside the fins and not at ends of the fins, heat can spread at 360° from each heat releasing area, which also improves the spreading of heat on the fins.

Such positions of the heat releasing areas means that the heat pipes are passing through fins, and thus the heat pipes are mechanically protected by the fins.

At a given volume, the system according to the invention is therefore more efficient than the system described in US9069535B2 at least because gravity helps in the heat transfer from the heat sources (CPU and GPU) to the radiator and because heat is better spread in the radiator.

Moreover, the freedom on the positions of the CPU, the GPU and the radiator makes possible to adapt to any shape of the computer, and especially on a cuboid shape, which is the standard shape for computers.

The cooling system according to the invention is also especially light and compact. Additionally, the cooling system according to the invention is especially silent because it does not require a fan. However, a fan can still be provided, depending on the heat expected from the CPU and GPU.

It is especially interesting to thermally connect both CPU and GPU to a same radiator because they are typically not warming up at the same moment. Therefore, when the CPU is generating a lot of heat, this heat can be spread even within the parts of the radiator that are thermally closer to the GPU, and when the GPU is generating a lot of heat, it can be distributed even within the parts of the radiator that are thermally closer to the CPU.

The cooling system according to the invention makes use of the chimney effect and convection to provide a cooling especially efficient.

It is possible, within the frame of the invention, that more that one CPU and/or GPU is thermally connected to the radiator. The fins are preferably in aluminum. The fins are preferably created by deep drawing and not by extrusion, which means that their mechanical connection can be especially light. In the present invention, the mechanical connection between the fins is preferably provided by rods.

In the frame of the present document, a heat pipe is preferably a heat-transfer device that combines the principles of thermal conductivity and phase transition to transfer heat between two solid interfaces. At the hot interface (heat receiving area), a liquid turns into a vapor by absorbing heat. The vapor then travels along the heat pipe to one or several cold interfaces (heat release areas) and condenses back into a liquid, thus releasing the latent heat. The liquid then returns to the hot interface through any of capillary action, centrifugal force, or gravity or a combination thereof, and the cycle repeats. A heat pipe is an elongated tube, preferably with a circular section. The diameter of its section is preferably at least ten times lower than its length.

In the frame of the present document, a first (respectively second) heat receiving area is an area of a first (respectively second) heat pipe where it receives heat from the CPU (respectively GPU). It is preferably the area where the first (respectively second) heat pipe is in mechanical and thermal contact with the first (respectively second) fastening means.

In the frame of the present document, a first (respectively second) heat releasing area is an area of a first (respectively second) heat pipe where it releases heat to a fin. For each first (respectively second) heat pipe, there is therefore a plurality of first (respectively second) heat releasing areas, each of them corresponding to a different fin. There are preferably the areas where the first (respectively second) heat pipe is in mechanical and thermal contact with the fins.

In a preferred embodiment of the invention, each of the first heat releasing areas is different from all the other first heat releasing areas and all the second heat releasing areas, and each of the second heat releasing areas is different from all the other second heat releasing areas and all the first heat releasing areas.

A second heat releasing area of a second heat pipe might be lower than a second heat receiving area for another second heat pipe.

The present invention covers any cooling system having the characteristics of any of the independent claims, even if it has also other characteristics. For example, a cooling system with heat pipes against gravity may still be within the scope of the present invention.

The cooling system according to the invention is designed to be placed in a first position. It corresponds to the normal position of use of the computer. Preferably, in this first position, the CPU and GPU, when attached with the fastening means, are at a height that corresponds to the lowest half of the radiator or they might be below the height of the radiator. The first position of the cooling system, which may be called first orientation, corresponds to a first position of the computer.

Preferably, the first and second heat pipes are rigid. Preferably, the fins are in parallel vertical plans when the cooling system is in the first position. Preferably, the first and second heat pipes are brazed to the fins.

The first and second heat pipes have preferably a diameter of 6 mm at most and a length of 350 mm at most. Indeed, a diameter of more than 6 mm would be less suitable for a personal computer. With a diameter of 6 mm or less, a length of more than 350 mm would create a decrease in the thermal transfer performances of the heat pipes.

In the frame of the present document, several elements may have a reference index from a to n. a typically represents the first of these elements. n typically represents the last of these elements. i typically represents any of these elements (including the first and the last). n can be different when considering different elements: for example, the number of first heat pipes may be different from the number of second heat pipes.

The CPU is preferably mounted on a first printed circuit board (PCB). The GPU is preferably mounted on a second PCB.

The first PCB is preferably between the CPU and the radiator. The GPU is preferably between the second PCB and the radiator.

The first part of at least some of the first heat pipes is preferably at least partially between the second PCB and some fins.

The CPU (respectively GPU) has preferably a first surface, which is directed to the first (respectively second) PCB and a second surface, opposite to the first surface, which is directed to the first (respectively second) fastening means and/or the first (respectively second) heat pipes.

In an embodiment of the invention, the cooling system comprises:
- first fastening means for fastening the central computing unit to the first thermal transfer means; and
- second fastening means for fastening the graphical computing unit to the second thermal transfer means.

The first fastening means preferably fasten the central computing unit to the first heat pipes. The second fastening means preferably fasten the graphical computing unit to the second heat pipes.

Preferably, the first (respectively second) heat pipes are unmovably fixed to the first (respectively second) fastening means. This prevents sliding, which makes the mechanical coupling especially reliable. This also provides an especially good thermal coupling.

Preferably, the first (respectively second) fastening means are suitable for fastening the first (respectively second) PCB to the first (respectively second) thermal transfer means, the CPU (respectively GPU) being fixed to the first (respectively second) PCB.

In an embodiment of the invention, the radiator mechanically supports the first heat pipes, which mechanically support the first fastening means, which are designed to mechanically support the central computing unit, and the radiator mechanically supports the second heat pipes, which mechanically support the second fastening means, which are designed to mechanically support the graphical computing unit.

In other words, there is a chain of mechanical couplings such that, in the first position, the radiator holds the weight of the first and second heat pipes, the first heat pipes hold the weight of the first fastening means, which holds the weight of the CPU, preferably via the first PCB, and the second heat pipes hold the weight of the second fastening means, which holds the weight of the GPU, preferably via the second PCB.

Therefore, since the first and second PCBs are fixed at given locations with respect to the cooling system and the computer through the heat pipes, the mechanical effort on the CPU and GPU during transport of the computer is especially small. For example, this mechanical effort is much smaller than if a heat sink was fixed on the CPU and/or GPU.

In an embodiment of the invention, the first fastening means provide a thermal coupling from the central computing unit to the first thermal transfer means and the second fastening means provide a thermal coupling from the graphical computing unit to the second thermal transfer means.

Therefore, the same device is used for both thermal and mechanical couplings, which is advantageous in terms of thermal coupling and robustness.

In an embodiment of the invention, the first fastening means comprises a first fixed part and a first movable part, the first fixed part being fixed to the first thermal transfer means, preferably to the first heat pipes, the first movable part being fastenable to a first printed circuit board, the central processing unit being mounted on the first printed circuit board, and the first movable part being movable in a first direction with respect to the first fixed part; and the second fastening means comprises a second fixed part and a second movable part, the second fixed part being fixed to the second thermal transfer means, preferably to the second heat pipes, the second movable part being fastenable to a second printed circuit board, the graphical processing unit being mounted on the second printed circuit board, and the second movable part being movable in a second direction with respect to the second fixed part, the first direction being different from the second direction.

Therefore, the cooling system may be connected to many types of commercial PCBs, even if the position of the CPU or GPU is different from one PCB to another. Moreover, the cooling system is thus compatible with a rigid electrical connector making the electrical connection between the first and the second PCBs.

The fastening between the first (respectively second) movable part and the first (respectively second) PCB is preferably removable.

The first (respectively second) fastening means are preferably such that the thermal and mechanical coupling can be achieved even if the CPU (respectively GPU) can vary in size and in position with respect to the PCB from one model to another. For example, the dimensions of the first (respectively second) fixed part can be at least twice the dimension of a typical CPU (respectively GPU).

Preferably, the first direction is perpendicular to the second direction.

In an embodiment of the invention, each of the first and second heat pipes passes through the fins in a straight line.

It creates heat releasing areas that are aligned for a given heat pipe. This makes the cooling system especially robust and its production especially easy. This straight line is part of the second part of the heat pipe.

Preferably, the part of each heat pipe that passes through the fins is perpendicular to the fins.

In an embodiment of the invention, the radiator has a first lateral side and the first and second heat pipes enter in the radiator through the first lateral side. This makes the production of the cooling system especially easy.

In an embodiment of the invention, the second heat pipes have a first part, the cooling system being such that a second printed circuit board may be at least partially received in a clearance space between the radiator and portions of the first part of at least some of the second heat pipes, the graphical computing unit being mounted on the second printed circuit board.

This provides an especially good use of the space inside the computer casing and an especially good cooling since the second heat pipes can be kept short. This also provides a computer that is especially robust since the components mounted on the second PCB are mechanically protected by the second heat pipes.

The PCB of the GPU (second PCB) is in general longer than the PCB of the CPU (first PCB). The inventors have found that such a clearance space is especially interesting to receive the long second PCB.

In an embodiment of the invention, the radiator comprises a first recess suitable for receiving components of a first printed circuit board, the central computing unit being mounted on the first printed circuit board.

The first PCB typically supports components with some height. The first recess makes possible to accommodate these components. This provides an especially good use of the space inside the computer casing and an especially good cooling since the first heat pipes can be kept short. The first recess is formed by a cut in at least some, preferably all, the fins of the radiator. Preferably, the first recess corresponds to a bottom corner of the radiator.

At least some fins have a first part, which is adjacent to the first recess, and a second part, which is separated from the first recess by the first part. The cooling system is preferably designed in such a way that the first heat pipes are in thermal contact with the first part of the fins and the second heat pipes are in thermal contact with the second part of the fins.

In an embodiment of the invention, the radiator comprises a second recess accommodating at least part of the first heat pipes. This provides an especially good use of the space inside the computer casing and an especially good cooling since the first heat pipes can be kept short. Preferably, the first heat pipes enter the radiator within the second recess.

The second recess is formed by a cut in at least some the fins of the radiator. These fins, which may be called the "second recess fins", are preferably the fins at the first lateral side of the radiator. The cooling system is preferably designed in such a way that only the second heat pipes release heat to the second recess fins.

In an embodiment of the invention, the radiator comprises rods holding the fins together.

The rods are preferably perpendicular to the fins. The rods provide the mechanical cohesion of the radiator. The rods are preferably parallel to the second parts of the first and/or second heat pipes.

With the rods, the fins can be held together without any bloc. It is advantageous since such a bloc is heavy and cumbersome.

In the frame of the present document, a rod can be any kind of elongated structure, preferably tubular with a section of any shape. It can be a bar, a pole, a stick.

The invention also relates to a computer comprising a cooling system according to any of the preceding claims, a central computing unit and a graphical computing unit.

The computer is preferably a personal computer.

The computer preferably further comprises a casing which includes corner frame structures, a top wall and a bottom wall. Each corner frame structure is an elongated structure that corresponds to a corner of the computer casing. A corner frame structure may also be called a "post" of the casing.

Preferably, the top wall comprises a grid or another structure with holes, to evacuate heat. Preferably, the computer is designed in such a way that convection is possible between the radiator and the air on the top of the computer.

The computer preferably comprises a rigid electrical connector making the electrical connection between the first and the second PCBs.

In an embodiment of the invention, the computer comprises two, three or four or more corner frame structures that are fastened, preferably directly, to the radiator, and preferably to the rods of the radiator.

The radiator preferably extends from a first to a second corner frame structures. The radiator therefore provides the mechanical rigidity to the computer. The combined mechanical and thermal functions of the radiator makes possible to keep the number of pieces and then the cost especially low.

In an embodiment of the invention, the computer comprises a fan and an additional device, for example a power supply unit or a hard drive, and the fan is located between the additional device and the cooling system.

The additional device is a powered device that requires to be electrically powered.

Even if there is no fan, it is preferred that the additional device is below the cooling system when the computer is in the first position. It avoids that this additional devices blocks the convection from the radiator.

The power supply unit is preferably a device that converts mains AC to low-voltage regulated DC power for the internal components of the computer.

The invention also relates to an assembly process comprising the steps of:
(a) providing a cooling system according to any embodiment of the invention;
(b) sliding a second printed circuit board between the radiator and a first part of at least some second heat pipes, the graphical computing unit being mounted on the second printed circuit board;
(c) fastening the second printed circuit board to the second thermal transfer means; and
(d) fastening a first printed circuit board to the first thermal transfer means, the central computing unit being mounted on the first printed circuit board.

The steps do not have to be carried out in the order (a)-(b)-(c)-(d). They can be carried out in any suitable order. This process is preferably used within a computer assembly.

Any of the following steps may be inserted at any point during this process:
- Providing a rigid electrical connector.
- Adjusting the position of the first and second printed circuit boards as function of the rigid electrical connector.
- Connecting electrically the first and second printed circuit boards by the rigid electrical connector.

The invention makes possible to use a rigid electrical connector between the two PCBs, which is much cheaper than a flexible electrical connector.

### Brief description of the figures

For a better understanding of the present invention, reference will now be made, by way of example, to the accompanying drawings in which:
- Figure 1 is side three-dimensional view of a cooling system according to an embodiment of the invention;
- Figure 2 illustrates elements of a computer comprising a cooling system according to an embodiment of the invention;
- Figure 3 illustrates elements of a computer comprising a cooling system according to an embodiment of the invention;
- Figure 4 illustrates a top view of a computer comprising a cooling system according to an embodiment of the invention;
- Figure 5 is a cross-section view of a possible arrangement of first fastening means of a cooling system according to an embodiment of the invention; and
- Figure 6 is a cross-section view of a possible arrangement of second fastening means of a cooling system according to an embodiment of the invention.

### Description of the invention

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Furthermore, the various embodiments, although referred to as "preferred" are to be construed as exemplary manners in which the invention may be implemented rather than as limiting the scope of the invention.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present invention, the only enumerated components of the device are A and B, and further the claim should be interpreted as including equivalents of those components.

On the figures, identical or analogous elements may be referred by a same number.
In the frame of the present document, the wordings "vertical", "horizontal", "bottom", "top", etc. refer to a first position of the cooling system and/or the computer.

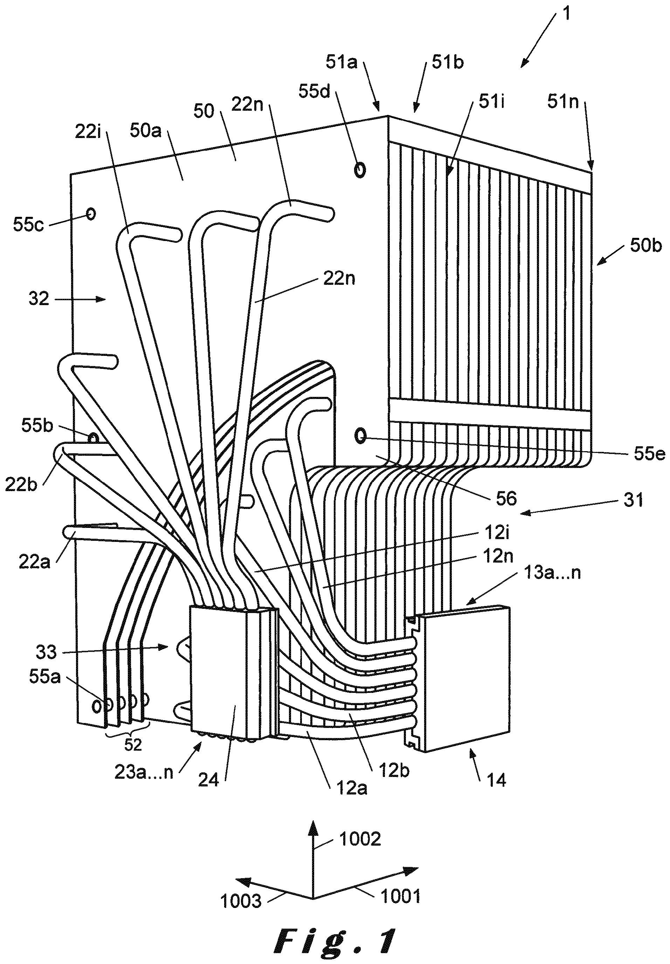

Figure 1 is side three-dimensional view of a cooling system 1 according to an embodiment of the invention.

The cooling system 1 includes a radiator 50 comprising fins 51a, 51b,..., 51i,... 51n. The fins 51a-n are preferably parallel plates of conductive material. The fins 51a-n are preferably vertical. The fins 51a-n are distributed in a first direction 1001, and extend through a second 1002 and third 1003 directions. Each of the first 1001, second 1002 and third 1003 directions is different from the others, preferably is perpendicular to the others.

The fins 51a-n preferably comprise a rectangular top part and a bottom part including a first recess 31, and, for some but not all fins 52, a second recess 33. The fins having a second recess 3 may be called second recess fins 52. The first recess 31 typically removes a rectangle at a corner of the fins 51a-n. The second recess 33 starts from the first recess 31 and further removes a arc of circle around the rectangle of the first recess 31. The second recess 33 may create a projecting part 56, or protrusion, in the second recess fins 52.

The radiator 50 preferably includes rods 55a, 55b, 55c, 55d, 55e. The rods 55a-e are preferably parallel to each others. The rods 55a-e are preferably perpendicular to the fins 51a-n. The rods 55a-e are firmly fixed to the fins 51a-n to hold them together in a fixed position. The rods 55a-e are fixed inside the fins 51a-n, i.e., not at ends of the fins 51a-n or on an edge of the fins 51a-n. Preferably, at least one rod 55e connects the projecting parts 56 of the second recess fins 52.

The cooling system 1 includes first thermal transfer means comprising first heat pipes 12a,..., 12i,..., 12n and second thermal transfer means comprising second heat pipes 22a,..., 22i,..., 22n.

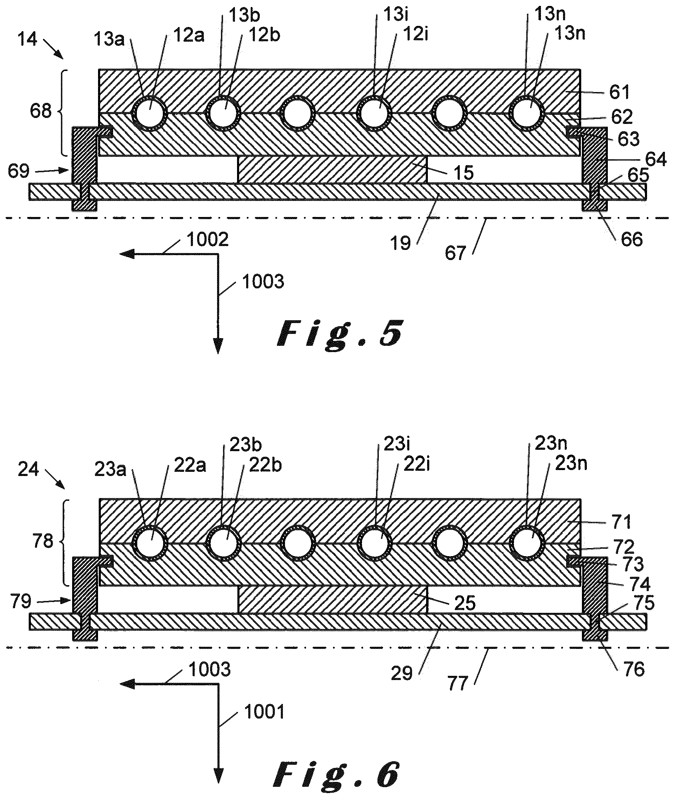

The first thermal transfer means are a thermal link between a central processing unit (CPU) 15 (visible on Figure 5) and the radiator 50. The second thermal transfer means are a thermal link between a graphical processing unit (GPU) 25 (visible on Figure 6) and the radiator 50.

The cooling system 1 preferably includes first fastening means 14 for fastening the CPU 15 to the first thermal transfer means and second fastening means 24 for fastening the GPU 25 to second first thermal transfer means.

Each 12i of the first heat pipes comprises at least one first heat receiving area 13i (visible on Figure 5) which is the area where the first heat pipe 12i receives heat, directly or indirectly, from the CPU 15, preferably when the CPU 15 is fastened with the first fastening means 14. The first heat receiving area 13i is preferably a portion of a cylindrical surface, for example corresponding to the contact surface between the first heat pipe 12i and the first fastening means 14.

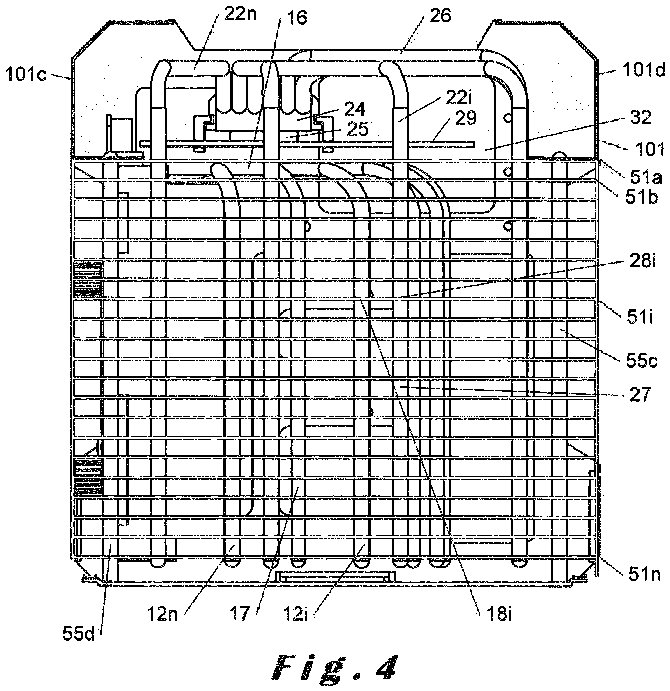

Each 12i of the first heat pipes comprises first heat releasing areas 18i (visible on Figure 4) which are the areas where the first heat pipe 12i releases heat, directly or indirectly, to the fins 51a-n. Each first heat release area 18i is preferably a portion of a cylindrical surface corresponding to the thermal transfer surface between the first heat pipe 12i and the fin 51i.

The first heat release areas 18i are inside the fin 51a-n, which means that the first heat release areas 18i are not at ends of the fins 51a-n or on an edge of the fins 51a-n. Preferably, at the first heat release area 18i, the first heat pipe 12i is surrounded over 360° by the fin 51i.

Each 22i of the second heat pipes comprises at least one second heat receiving area 23i (visible on Figure 6) which is the area where the second heat pipe 22i receives heat, directly or indirectly, from the GPU 25, preferably when the GPU 25 is fastened with the second fastening means 24. The second heat receiving area 23i is preferably a portion of a cylindrical surface, for example corresponding to the contact surface between the second heat pipe 22i and the second fastening means 24.

Each 22i of the second heat pipes comprises second heat releasing areas 28a-n (visible on Figure 4) which are the areas where the second heat pipe 22i releases heat, directly or indirectly, to the fins 51a-n. Each second heat release area 28i is preferably a portion of a cylindrical surface corresponding to the thermal transfer surface between the second heat pipe 22i and the fin 51i.

The second heat release areas 28i are inside the fin 51a-n, which means that the second heat release areas 28i are not at ends of the fins 51a-n or on an edge of the fins 51a-n. Preferably, at the second heat release area 28i, the second heat pipe 22i is surrounded over 360° by the fin 51i.

The first 18i and second 28i heat release areas are preferably all spaced apart from each other.

The first fastening means 14 are preferably suitable for mechanically and thermally coupling the CPU 15 to all first heat pipes 12a-n, possibly via the first PCB 19. An exemplary embodiment of the first fastening means 14 will be described in more details with respect to Figure 5. The second fastening means 24 are preferably suitable for mechanically and thermally coupling the GPU 25 to all second heat pipes 22a-n, possibly via the second PCB 29. An exemplary embodiment of the second fastening means 24 will be described in more details with respect to Figure 6.

Figure 1 shows the cooling system 1 in a first position, which is its normal position in use. In the first position, every first 12i (respectively second 22i) heat pipe has its heat receiving area 13i (respectively 23i) at a lower height or at a same height than its heat releasing areas 18i (respectively 28i). In the first position, the first 1001 and third 1003 directions are horizontal and the second direction 1002 is vertical.

Each first heat pipe 12i has a first part 16, which is outside the fins 51a-n, and a second part 17, which is inside the fins 51a-n. They are visible for example on Figure 4. Each second heat pipe 22i has a first part 26, which is outside the fins 51a-n, and a second part 27, which is inside the fins 51a-n. They are visible for example on Figure 4.

The second parts 17, 27 of the first and second heat pipes are preferably parallel to each others. They are preferably parallel to the first direction 1001. They are preferably perpendicular to the fins 51a-n.

The first parts 16 of the first heat pipes 12a-n have preferably:
- a first portion, which includes the first heat receiving area 13a-n, wherein they are parallel to the first direction 1001;
- a second portion, with preferably a component parallel to the second direction 1002, to climb before entering the radiator 50; and
- a third portion, which is a bend to get parallel to the first direction 1001 before entering the radiator 50.

The second and third portions are preferably at least partially in the second recess 33.

The radiator 50 has a first lateral side 50a. The first lateral side 50a is preferably perpendicular to the first direction 1001. Preferably, all first 12a-n and second 22a-n heat pipes penetrate into the radiator 50 by this first lateral side 50a. In an embodiment of the invention, the GPU 25 is parallel to the first lateral side 50a of the radiator 50.

The radiator 50 has a second lateral side 50b, secant to the first lateral side 50a, and preferably perpendicular to the third direction 1003. In an embodiment of the invention, the CPU 15 is parallel to the second lateral side 50b of the radiator 50.

In an embodiment of the invention, at least part of the first heat pipes 12a-n is in the second recess 33. Preferably, the first heat pipes 12a-n penetrates into the radiator within the second recess 33.

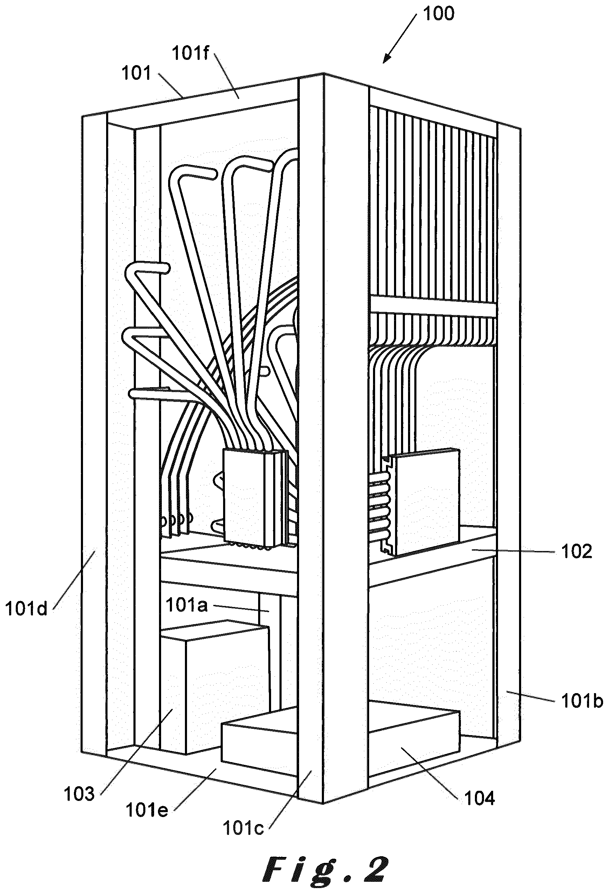

Figure 2 illustrates elements of a computer 100 comprising a cooling system 1 according to an embodiment of the invention. For clarity reasons, some of the elements of the computer 100 are not shown on Figure 2.

Figure 2 shows the computer 100 in a first position, which is its normal position in use.

The computer 100 includes the cooling system 1, the CPU 15 and the GPU 25. Preferably, the computer 100 includes a casing 101 and at least one additional device such as a power supply unit and/or a hard drive 104. The computer 100 may also include a fan 102. The fan 102 is preferably located directly below the radiator 50 when the computer 100 is in the first position. The fan 102 is preferably located between the additional device and the cooling system 1.

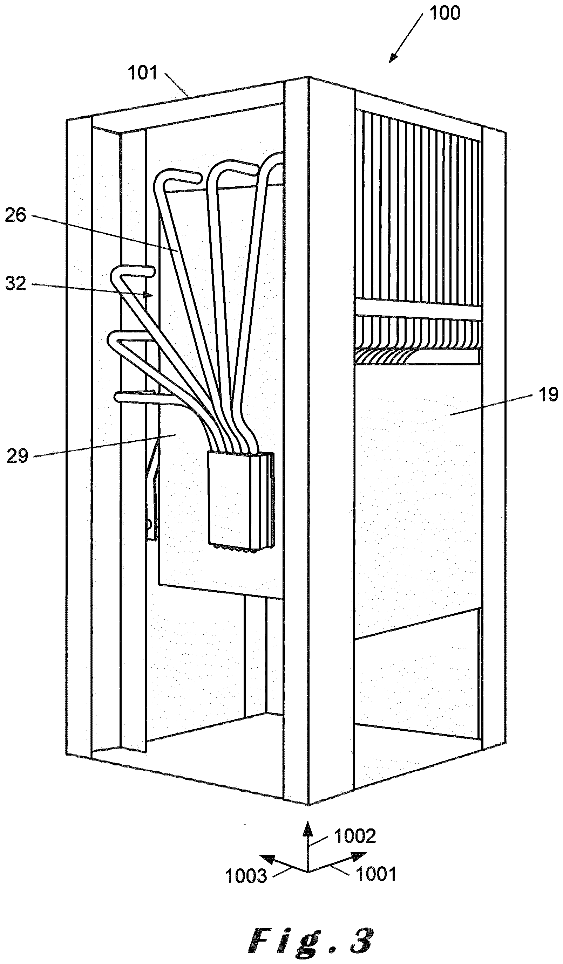

The computer 100 preferably includes a first PCB 19 (visible on Figure 3), the CPU 15 being mounted on the first PCB 19, and a second PCB 29 (visible on Figure 3), the GPU 25 being mounted on the second PCB 29.

The casing 101 is preferably a cuboid. The casing 101 preferably comprises a first 101a, a second 101b, a third 101c and a fourth 101d corner frame structures in order to define four edges of the cuboid. At least two of them are fastened, preferably directly, to the radiator 50, preferably via at least some of the rods 55. The four corner frame structures 101 are essential vertical in the first position. Preferably, the first 101a and second 101b corner frame structures are U-shaped with branches along the third direction 1003. A first branch of the U is on the external surface of the casing 101 and a second branch of the U is inside the casing and some rods 55 are fixed to it.

The casing 101 preferably includes a bottom wall 101e and a top wall 101f. It may also include four lateral walls, which are not represented.

The top wall 101e is preferably a grid to improve convection from the radiator 50. The top wall 101e is preferably adjacent to the radiator 50.

In the computer 100 according to the invention, the structural robustness is preferably mostly provided by the radiator 50.

Figure 3 illustrates elements of the computer 100 comprising a cooling system 1 according to an embodiment of the invention. For clarity reasons, some of the elements of the computer 100 are not shown on Figure 3. Figure 3 shows the computer 100 in a first position, which is its normal position in use.

In the present invention, the cooling system 1 is designed in such a way that the CPU 15 and the first PCB 19 are kept in the air by the first fastening means 14, the first heat pipes 12a-n and the radiator 50, and the GPU 25 and the second PCB 29 are kept in the air by the second fastening means 25, the second heat pipes 22an and the radiator 50.

In the preferred embodiment, the CPU 15 (respectively GPU 25) is fastened to the first 19 (respectively second 29) PCB in a fixed way. The first 14 (respectively second 24) fastening means fasten the first 19 (respectively second 29) PCB to the first 12a-n (respectively second 22a-n) heat pipes with some freedom in the adjustment. However, once the first 19 (respectively second 29) PCB is fastened to the first 12a-n (respectively second 22a-n), their respective position is fixed. The first 12a-n (respectively second 22a-n) heat pipes are fastened to the radiator 50 in a fixed way. The radiator 50 is kept in the air within the computer 100, for example because of at least two of the corner frames structures.

The cooling system 1 is designed in such a way that there is a clearance space 32 between the first lateral side 50a of the radiator 50 and portions of the first parts 26 of the second heat pipes 22a-n. Part of the second PCB 29 is received in this clearance space 32.

The first PCB 19 is preferably parallel to the fins 51a-n. The CPU 15 is preferably parallel to the fins 51a-n. The second PCB 29 is preferably perpendicular to the fins 51a-n. The GPU 25 is preferably perpendicular to the fins 51a-n.

The first 19 (respectively second 29) PCB has a first surface where PCB components and the CPU 15 (respectively GPU 25) are mounted, and a second surface, opposite to the first surface.

The first surface of the first PCB 19 is directed towards the radiator 50. The second surface of the second PCB 29 is directed towards the radiator 50.

The cooling system 1 is preferably designed in such a way that the first recess 31 is suitable for receiving at least some of the components mounted on the first PCB 19.

The cooling system 1 is designed in such a way that the first PCB 19 may be inserted in the first direction 1001 for being fastened by the first fastening means 14 and the second PCB 29 may be inserted in the second direction 1002 for being fastened by the second fastening means 25.

Figure 4 illustrates a top view of the computer 100 comprising a cooling system 1 according to an embodiment of the invention. The second parts 17, 27 of the first 12 and second 22 heat pipes passes through the fins 51a-n in straight lines.

Preferably, the radiator 51 is fastened to the casing 101 through at least some of the rods 55a-e.

Figure 5 is a cross-section view of a possible arrangement of first fastening means 14 of a cooling system 1 according to an embodiment of the invention.

In an embodiment of the invention, the first fastening means 14 comprise a first fixed part 68 and a first movable part 69. The first fixed part 68 is fixed to the first thermal transfer means, preferably to the first heat pipes 12a-n, preferably in a unremovable way. The first movable part 69 is fixed to the first PCB 19, preferably in a removable way.

The first movable part 69 is movable in the first direction 1001 with respect to the first fixed part 68. For example, the first movable part 69 may comprise a rib 63 which can be received and slide along the first direction 1001 in a slit of the first fixed part 68. The first movable part 69 may further comprise four times a first fastening element 64, a second fastening element 65 and a third fastening element 66. The first fastening element 64 is fixed and perpendicular to the rib 63.

The second fastening element 65 joins the first 64 and third 66 fastening elements. It is designed to pass into a hole of the first PCB 19. The first 64 and third 66 fastening elements are larger than the second fastening element 65 and than the hole in the first PCB 19, to block the first movable part 69 with respect to the first PCB 19. The first 64 or third 66 fastening element is removable, for example by screwing, from the second fastening element 65.

The first fixed part 68 is in thermal contact with the CPU 15, preferably over at least the full second surface of the CPU 15. A thermal paste is preferably provided between the second surface of the CPU 15 and the first fixed part 68.

In an embodiment of the invention, the first fixed part 68 comprises a block of conductive material with cylindrical holes wherein the first heat pipes 12a-n are mechanically blocked. This block may comprise an internal block 62 of a first material (for example copper) and an external block 61 of a second material (for example aluminum) different from the first material.

The CPU 15, and preferably the first PCB 19, is parallel to a first plan 67.

Figure 6 is a cross-section view of a possible arrangement of second fastening means 24 of a cooling system 1 according to an embodiment of the invention.

In an embodiment of the invention, the second fastening means 24 comprise a second fixed part 78 and a second movable part 79. The second fixed part 78 is fixed to the second thermal transfer means, preferably to the second heat pipes 22an, preferably in a unremovable way. The second movable part 79 is fixed to the second PCB 29, preferably in a removable way.

The second movable part 79 is movable in the second direction 1002 with respect to the second fixed part 78. For example, the second movable part 79 may comprise a rib 73 which can be received and slide along the second direction 1002 in a slit of the second fixed part 78. The second movable part 79 may further comprise four times a first fastening element 74, a second fastening element 75 and a third fastening element 76. The first fastening element 74 is fixed and perpendicular to the rib 73.

The second fastening element 75 joins the first 75 and third 76 fastening elements. It is designed to pass into a hole of the second PCB 29. The first 74 and third 76 fastening elements are larger than the second fastening element 75 and than the hole in the second PCB 29, to block the second movable part 79 with respect to the second PCB 29. The first 74 or third 76 fastening element is removable, for example by screwing, from the second fastening element 75.

The second fixed part 78 is in thermal contact with the GPU 25, preferably over at least the full second surface of the GPU 25. A thermal paste is preferably provided between the second surface of the GPU 25 and the second fixed part 78.

In an embodiment of the invention, the second fixed part 78 comprises a block of conductive material with cylindrical holes wherein the second heat pipes 22a-n are mechanically blocked. This block may comprise an internal block 72 of a first material (for example copper) and an external block 71 of a second material (for example aluminum) different from the first material.

The GPU 25, and preferably the second PCB 29, is parallel to a second plan 77, secant, i.e., non-parallel, to the first plan 67. The first and second plans make preferably and angle between 70° and 120°, the first plan is preferably perpendicular to the second plan. The first and the second plans have preferably an angle of less than 30° to the vertical. they are preferably vertical

An assembly process according to the invention may comprise the following steps.

A cooling system 1 according to any embodiment of the present invention is provided.

A standard first PCB 19, with a CPU 15 and a first electrical connector mounted on it, is provided. Four holes are made on it, close to each corner of the CPU 15, and the first movable part 69 of the first fastening means 14 is fixed to the first PCB 19 via these holes.

A standard second PCB 29, with a GPU 25 and a second electrical connector mounted on it, is provided. Four holes are made on it, close to each corner of the GPU 25, and the second movable part 79 of the second fastening means 24 is fixed to the second PCB 29 via these holes.

The second PCB 29, with the GPU 25, the second electrical connector and the second movable part 79, is coupled to the cooling system 1 with a sliding of the rib 73 in the slit of the second fixed part 78 along the second direction 1002 and a sliding of at least part of the second PCB 29 in the clearance space 32.

The first PCB 19, with the CPU 15, the first electrical connector and the first movable part 69, is coupled to the cooling system 1 with a sliding of the rib 63 in the slit of the first fixed part 68 along the first direction 1001.

A rigid electrical connector is provided. The respective positions of the first 19 and second PCB 29 are adjusted by sliding in the first direction 1001 for the first PCB 19 and in the second direction 1002 in order to connect electrically and mechanically the rigid electrical connector between the first and the second electrical connectors.

The cooling system 1 is preferably designed in such a way that a user can buy a first commercial PCB, with the CPU, and a second commercial PCB, with the GPU, and mount them to the cooling system to obtain a computer with an excellent cooling.

In other words, the invention relates to a cooling system 1 for a computer. The cooling system 1 comprises a radiator 50 with fins 51a-n, first heat pipes 12a-n and second heat pipes 22a-n. The first heat pipes 12a-n can be thermally connected to a central computer unit 15 to extract its heat. The second heat pipes 22a-n can be thermally connected to a graphical computer unit 25 to extract its heat. The heat is then transferred by the first and second heat pipes to the fins at heat releasing areas 18i, 28i. For each fin, the heat releasing areas of the various heat pipes are distributed within the fin to efficiently distribute the heat on its full external surface.

Although the present invention has been described above with respect to particular embodiments, it will readily be appreciated that other embodiments are also possible.

## Claims

1. Cooling system (1) for a computer comprising:
• a radiator (50) comprising fins (51a-n);
• first thermal transfer means arranged for transferring heat from a central computing unit (15) to the radiator (50);
• second thermal transfer means arranged for transferring heat from a graphical computing unit (25) to the radiator (50);
**characterized in that**
the first thermal transfer means comprise first heat pipes (12an), each first heat pipe (12i) being arranged for receiving heat from the central computing unit (15) over a first heat receiving area (13i);
the second thermal transfer means comprise second heat pipes (22a-n), each second heat pipe (22i) being arranged for receiving heat from the graphical computing unit (25) over a second heat receiving area (23i);
the first (12a-n) heat pipes are in thermal contact with at least some of the fins (51a-n) over first heat releasing areas (18a-n), and the second (22a-n) heat pipes are in thermal contact with at least some of the fins (51a-n) over second heat releasing areas (28a-n), the first (18i) and second (28i) releasing areas being different from each others and being inside the fins (51i); and
the cooling system (1) has a first position such that:
• for each first heat pipe (12i), the first heat releasing areas (18i) are at a same height or higher than the first heat receiving area (13i),
• for each second heat pipe (22i), the second heat releasing areas (28i) are at a same height or higher than the second heat receiving area (23i).

2. Cooling system (1) according to claim 1 comprising:
• first fastening means (14) for fastening the central computing unit (15) to the first thermal transfer means; and
• second fastening means (24) for fastening the graphical computing unit (25) to the second thermal transfer means.

3. Cooling system (1) according to the preceding claim, wherein the radiator (50) mechanically supports the first heat pipes (12a-n), which mechanically support the first fastening means (14), which are designed to mechanically support the central computing unit (15), and the radiator (50) mechanically supports the second heat pipes (22a-n), which mechanically support the second fastening means (24), which are designed to mechanically support the graphical computing unit (25).

4. Cooling system (1) according to claim 2 or 3, wherein the first fastening means (14) provide a thermal coupling from the central computing unit (15) to the first thermal transfer means and the second fastening means (24) provide a thermal coupling from the graphical computing unit (25) to the second thermal transfer means.

5. Cooling system (1) according to any of claims 2 to 4, wherein the first fastening means (14) comprises a first fixed part (68) and a first movable part (69), the first fixed part (68) being fixed to the first thermal transfer means, preferably to the first heat pipes (12a-n), the first movable part (69) being fastenable to a first printed circuit board (19), the central processing unit (15) being mounted on the first printed circuit board (19), and the first movable part (69) being movable in a first direction (1001) with respect to the first fixed part (68); and the second fastening means (24) comprises a second fixed part (78) and a second movable part (79), the second fixed part being (78) fixed to the second thermal transfer means, preferably to the second heat pipes (22a-n), the second movable part (79) being fastenable to a second printed circuit board (29), the graphical processing unit (25) being mounted on the second printed circuit board (29), and the second movable part (79) being movable in a second direction (1002) with respect to the second fixed part (68), the first direction (1001) being different from the second direction (1002).

6. Cooling system (1) according to any the preceding claims, wherein each of the first (12a-n) and second (22a-n) heat pipes passes through the fins (51a-n) in a straight line.

7. Cooling system (1) according to any the preceding claims, wherein the radiator (50) has a first lateral side (50a) and the first (12a-n) and second (22a-n) heat pipes enter in the radiator (50) through the first lateral side (50a).

8. Cooling system (1) according to any the preceding claims, wherein the second heat pipes (22) have a first part (26), the cooling system being such that a second printed circuit board (29) may be at least partially received in a clearance space (32) between the radiator (50) and portions of the first part (26) of at least some of the second heat pipes (22), the graphical computing unit (25) being mounted on the second printed circuit board (29).

9. Cooling system (1) according to any the preceding claims, wherein the radiator (50) comprises a first recess (31) suitable for receiving components of a first printed circuit board (19), the central computing unit (25) being mounted on the first printed circuit board (19).

10. Cooling system (1) according to any the preceding claims, wherein the radiator (50) comprises a second recess (33) accommodating at least part of the first heat pipes (12a-n).

11. Cooling system (1) according to any the preceding claims, wherein the radiator (50) comprises rods (55a-e) holding the fins (51a-n) together.

12. Computer (100) comprising a cooling system (1) according to any of the preceding claims, a central computing unit (15) and a graphical computing unit (25).

13. Computer according to the preceding claim, comprising two, three or four corner frame structures (101) that are fastened, preferably directly, to the radiator (50).

14. Computer according to claim 12 or 13, comprising a fan (102) and an additional device being a power supply unit (103) or a hard drive (104), wherein the fan (102) is located between the additional device and the cooling system (1).

15. Assembly process comprising the steps of:
(a) providing a cooling system (1) according to any of claim 1 to 11;
(b) sliding a second printed circuit board (29) between the radiator (50) and a first part (26) of at least some second heat pipes (22), the graphical computing unit (25) being mounted on the second printed circuit board (29);
(c) fastening the second printed circuit board (29) to the second thermal transfer means; and
(d) fastening a first printed circuit board (19) to the first thermal transfer means, the central computing unit (15) being mounted on the first printed circuit board (19).
